(19) Europäisches Patentamt
European Patent Office
Office européen des brevets

(11) EP 3 470 368 A1

(12) DEMANDE DE BREVET EUROPEEN

(43) Date de publication:
17.04.2019 Bulletin 2019/16

(21) Numéro de dépôt: 18199969.9

(22) Date de dépôt: 11.10.2018

(51) Int Cl.:
C01B 32/168 (2017.01)        C23C 16/26 (2006.01)
H01B 1/04 (2006.01)          H01B 5/14 (2006.01)
H01L 29/12 (2006.01)         H01M 4/62 (2006.01)
H01L 51/00 (2006.01)

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 12.10.2017 FR 1759550

(71) Demandeur: Commissariat à l'Energie Atomique
et aux Energies
Alternatives
75015 Paris (FR)

(72) Inventeurs:
• DIJON, Jean
  38800 CHAMPAGNIER (FR)
• LE POCHE, Hélène
  38000 GRENOBLE (FR)

(74) Mandataire: Nony
11 rue Saint-Georges
75009 Paris (FR)

(54) PROCÉDÉ DE DOPAGE DE NANOTUBES DE CARBONE

(57) La présente invention concerne un procédé utile pour préparer une couche de nanotubes de carbone, en particulier transparente, et de conductivité électrique améliorée et stabilisée, ledit procédé comprenant au moins les étapes consistant à :

(i) disposer d'au moins une couche de nanotubes de carbone, en particulier transparente, possédant une résistance carrée, $R\square ini$,

(ii) doper au moins une zone de ladite couche de nanotubes de carbone pour former une zone de nanotubes de carbone dopée ayant une résistance carrée stabilisée, $R\square\infty$, de valeur inférieure à $R\square ini$.

caractérisé en ce que l'étape (ii) est réalisée par pulvérisation, en surface d'au moins ladite zone de ladite couche de nanotubes de carbone (i), d'au moins un dopant choisi parmi les sels et complexes organométalliques de platine ou de palladium de degré d'oxydation +IV ou +II et en ce que de préférence la zone de nanotubes de carbone dopés possède en outre une valeur de transmittance supérieure à 80% sur l'ensemble du spectre du visible.

FIGURE 1

## Description

La présente invention est relative au dopage chimique des nanotubes de carbone par transfert de charge pour augmenter leur conductivité électrique. La présente invention est également relative à un procédé utile pour accroître, par dopage chimique, la conductivité électrique de nanotubes de carbone, y compris transparent, tout en leur conservant une transparence satisfaisante le cas échéant. Les domaines d'applications sont les couches minces transparente conductrices à base de nanotubes et de nanobuds (A.G. Nasibulin et al. / Chemical Physics Letters 446 (2007) 109-114), les interconnexions à base de nanotubes et les câbles à base de nanotubes. Les nanotubes de carbone ainsi dopés s'avèrent ainsi tout particulièrement intéressants pour constituer des électrodes conductrices, y compris transparentes, pour des dispositifs d'affichage ou des cellules solaires, pour des dispositifs électroniques à base de nanotubes de carbone ou encore pour des interconnexions à base de nanotubes de carbone. Le procédé de dopage selon la présente invention induit un dopage stable et efficace, compatible grande surface.

Actuellement, les nanotubes, déposés sur un substrat pour former un réseau aléatoire conducteur constitutif des électrodes transparentes conductrices ou utilisés pour faire des connexions électriques combinent une forte conductivité électrique et une transparence élevée. Malheureusement, la conductivité des tubes est généralement insuffisante et les tubes sont un mélange de tubes métalliques et semi-conducteurs dans le cas des tubes mono parois (SWCNT), ou ils correspondent à un mélange de parois semis conductrices et conductrices dans le cas des tubes multi parois (MWCNT). C'est pourquoi il existe un besoin de disposer de procédés utiles pour doper les nanotubes de carbone pour améliorer la conduction et en particulier rendre plus métalliques les parois semi conductrices.

Le dopage des nanotubes est soit réalisé à haute température en substituant des atomes de carbone par des atomes d'azote ou de bore, soit en adsorbant des molécules sur la surface du tube qui le dopent par transfert de charge. Dans le premier cas, l'efficacité de dopage est assez mauvaise et n'est pas compatible avec un dopage réalisé post croissance sur des substrats organiques. Dans le deuxième cas, un exemple de dopant est l'iode qui s'adsorbe sur les parois ou rentre à l'intérieur des tubes s'ils sont ouverts. Le dopage obtenu est de type p. L'iode malgré son efficacité n'est pas utilisable en particulier sur des substrats en polymère car le polymère est détruit (carbonisé) par la présence d'iode lors du procédé de dopage généralement réalisé en phase gazeuse.

Une autre façon de doper les tubes est de les immerger dans des solutions dopantes. Le dopage par immersion dans l'acide (acide nitrique, acide chloridrique, acide sulfurique) est utilisé (Ralf Graupner Phys. Chem. Chem. Phys., 2003, 5, 5472-5476) mais n'est pas très stable en température. Des chlorures métalliques en particulier le chlorure d'or ont également été étudiés (Kim et al. acsnano Vol. 5 No. 2 1236-1242 (2011)) l'efficacité de dopage décroit en température (au-delà de 100°C). Des nanoparticules métalliques ont également été utilisées en particulier des nanoparticules de platine (Kim et al. acsnano VOL. 3 ▪ NO. 9 ▪ 2818-2826 ▪ (2009)) déposées par électrochimie. Ce Procédé est par ailleurs difficilement compatible avec un procédé grande surface ou « roll to roll ».

En conséquence, il n'existe à ce jour, à la connaissance des inventeurs, aucune méthode de dopage d'une couche de nanotubes de carbone qui soit compatible avec un dopage basse température ayant une forte efficacité de dopage et une bonne stabilité thermique et temporelle. Par ailleurs les procédés utilisés sont peu compatibles avec des films grande surface ou avec un procédé « roll to roll ». Enfin, le besoin d'une méthode permettant d'accéder à des nanotubes de carbone en minimisant l'absorption optique et en maximisant la conductivité électrique persiste. En effet, une couche de nanotubes minimale est généralement recherchée car un excès de dopant accroit l'absorption optique.

La présente invention a précisément pour objet de proposer une nouvelle méthode de dopage répondant à l'ensemble de ces exigences.

En particulier, la présente invention vise à proposer un procédé utile pour accéder à un dopage chimique efficace et stabilisé, d'une couche de nanotubes de carbone transparente tout en préservant à cette couche une transmittance d'au moins 80%.

Elle vise en outre à proposer une nouvelle technique de dopage qui soit compatible avec une mise en oeuvre sur des couches de carbone à grande échelle notamment avec des méthodes au défilé de type « roll to roll » et supportées sur des substrats flexibles, en particulier, contrairement aux techniques de dépôt des dopants par « spin-coating » et « dropping ».

Plus précisément, selon un premier aspect, la présente invention concerne un procédé utile pour préparer une couche de nanotubes de carbone, en particulier transparente, de conductivité électrique améliorée et stabilisée, ledit procédé comprenant au moins les étapes consistant à :

> (i) disposer d'au moins une couche de nanotubes de carbone, en particulier transparente, possédant une résistance carrée, R☐uini et
> (ii) doper au moins une zone de ladite couche de nanotubes de carbone pour former une zone de nanotubes de carbone dopée ayant une résistance carrée stabilisée, R☐∞, de valeur inférieure à R☐ini,

caractérisé en ce que l'étape (ii) est réalisée par pulvérisation, en surface d'au moins ladite zone de ladite couche de nanotubes de carbone (i), d'au moins un dopant choisi parmi les sels et complexes organométalliques de platine ou de palladium de degré d'oxydation +IV ou +II.

Avantageusement, la quantité en dopant $Q_D$ est ajustée pour former une zone de nanotubes de carbone dopée et dotée de la résistance carrée stabilisée et minimisée, R□∞ attendue.

Selon une variante préférée, la zone de nanotubes de carbone dopée possède en outre une valeur de transmittance supérieure à 80% sur l'ensemble du spectre du visible.

Au sens de l'invention une résistance carrée stabilisée, ou encore R□∞, est une résistance carrée dont la valeur ne s'accroît pas significativement, en particulier de plus de 8 %, de sa valeur lors du vieillissement temporel de la couche de nanotubes de carbone dopée, dans les conditions ambiantes (air, humidité).

Contre toute attente, les inventeurs ont en effet constaté, que sous réserve du choix de dopants particuliers, d'un ajustement de leur quantité au niveau du dopage et d'un mode de dopage conforme à l'invention, il s'avère possible d'accéder à des couches de nanotubes de carbone dopées qui sont dotées d'un gain de conductivité significatif et stabilisé dans le temps.

Il est rappelé que la résistance carrée, dite encore « résistance surfacique » (appelée « sheet résistance » en anglais), peut être définie par la formule suivante :

$$R\square = \frac{\rho}{e} = \frac{1}{\sigma.e}$$

dans laquelle :

- e représente l'épaisseur du film conducteur (en cm) ;
- σ représente la conductivité du film (en S/cm) (σ=1/ρ) ; et
- ρ représente la résistivité du film (en Ω.cm).

Il est également rappelé que le dopage d'une couche de nanotubes de carbone a pour effet immédiat de réduire la résistance carrée R□ini, de cette couche à une valeur R□D.

Toutefois, comme évoqué dans le préambule du présent texte, il n'est généralement pas possible de conserver cette valeur R□D, mesurée juste après dépôt. Elle est altérée significativement au cours du vieillissement temporel de la couche de nanotubes de carbone dopés et ceci se traduit par une perte progressive de l'efficacité du dopage.

Le procédé selon l'invention permet précisément de conserver dans le temps l'efficacité du dopage.

La résistance carrée stabilisée, R□∞ obtenue selon le procédé selon l'invention, figure donc une valeur de R□ stable dans le temps.

Ainsi, le procédé de l'invention permet avantageusement de garantir un gain de conductivité à la zone de nanotubes de carbone dopés tout au long de son vieillissement.

Ce gain d'efficacité est notamment obtenu selon l'invention grâce à la mise en oeuvre d'une quantité en excès de dopants.

Au sens de l'invention, l'expression « quantité en excès de dopant » fait référence à des quantités en dopant supérieures ou égales à la quantité minimale requise en dopants au-dessus de laquelle la valeur de R□D ne varie plus ou ne diminue plus voire ne décroît pas plus de 8% de sa valeur, lorsque des dopants sont rajoutés à la surface de la couche de nanotubes de carbone.

Par contre, l'efficacité du dopage après stabilisation est d'autant plus importante, ou R□∞ est d'autant plus faible, que la quantité de dopants est élevée.

En outre, selon un mode préféré de l'invention, cette quantité en excès de dopants présents au sein de la zone de nanotubes de carbone dopée, qui est efficace pour procurer à ladite zone de nanotubes de carbone dopée une résistance carrée R□∞ minimisée, est en outre efficace pour permettre à la zone de nanotubes de carbone dopée, de manifester une transparence et en particulier d'une transmittance d'au moins 80% sur l'ensemble du spectre du visible.

Avantageusement, la couche de nanotubes de carbone de l'étape (i) du procédé est supportée par un substrat.

De préférence, le substrat est transparent ou translucide dans le domaine du visible ou de l'infra-rouge et de préférence choisi parmi le verre, polyéthylène téréphtalate

(PET), polycarbonate (PC), polyimide (PI), polyéthylène naphtalate (PEN), polydiméthylsiloxane (PDMS), polystyrène (PS), polyether sulfone (PES), du silicium recouvert d'une couche d'oxyde telle que SiOx ou $Al_2Ox$, ou d'une couche de nitrure, de préférence choisi parmi du verre et du polyéthylène téréphtalate.

Les nanotubes élaborés par CVD pour réaliser les couches minces transparentes sont déposés soit par voie humide trempage (Nanotechnology 19 (2008) 205703) spin coating ou spray (Science and Technology of Advanced Materials, 2016 Vol. 17, No. 1, 493-516) soit par voie sèche en utilisant des nanotubes dit super alignés (SACNT) (Adv. Funct. Mater. 2010, 20, 885-891) qui sont obtenus à partir d'un tapis filable de nanotubes de carbone soit par des méthodes de catalyseur flottant (Floating catalyst) qui fournissent des nanotubes mono parois de grande longueur (A. Kaskela et al. / Carbon 103 (2016) 228-234). Pour les films non transparents on peut utiliser les méthodes de couchage de nanotubes de carbone (ACS Nano, 2008, 2 (9), pp 1871-1878) soit en partant d'un tapis continu soit en utilisant des feuillets de nanotubes parallèles (Y. Hayamizu, nature nano. 3, 289, (2008)). Pour les interconnexions, on peut réaliser des lignes de nanotubes (bundle ou tubes individuel) en gravant les tapis couchés ou en utilisant de la croissance dans des via tel que décrit dans la publication (carbon 60 (2013) 139-145).

Selon une variante de réalisation, la couche de nanotubes de carbone de l'étape (i) est directement au contact du substrat.

Avantageusement, le dopant est choisi parmi :

- les sels de platine ou de palladium de formules :
  $A_2MX_6$, $MX_4$, $A_2MX_4$ et $MX_2$
  dans lesquelles :

  - A est un atome d'hydrogène, un groupe $NH_4$, un atome de sodium, un atome de lithium ou un atome de potassium ;
  - X est un atome de fluor, un atome de chlore, un atome de brome ou un atome d'iode ; et
  - M est un atome de platine ou un atome de palladium de degré d'oxydation +IV ou +II.

De préférence, le dopant est choisi parmi les sels de $PtCl_4$, $H_2PtCl_6$, $H_2PtCl_4$, $PtCl_2$, $H_2PdCl_6$, $PdCl_2$, $K_2PdCl_4$ et leurs mélanges et est de préférence le $PtCl_4$.

Selon un mode de réalisation préféré, le ou les dopants considérés selon l'invention sont mis en oeuvre au sein d'une solution liquide.

Selon un mode de réalisation préféré, la solution liquide de dopant(s) est pulvérisée par l'intermédiaire d'une buse fixe ou d'une buse mobile.

De préférence, la solution liquide de dopant(s) est pulvérisée de manière automatique au moyen d'une buse soumise à des vibrations ultrasoniques.

En particulier, l'opération de pulvérisation au niveau de la couche de nanotubes de carbone peut être réalisée en une fois ou répétée une à plusieurs fois.

Selon un mode de réalisation particulier, un masque pochoir peut être intercalé entre la buse et la couche de nanotubes de carbone à doper pour délimiter une zone de dopage.

Selon une variante de réalisation préférée, l'étape (ii) du procédé selon l'invention est réalisée en mode dynamique selon une technique de dopage au défilé et en particulier de type « roll-to-roll ».

Avantageusement, le substrat supportant la couche de nanotubes de carbone traitée en étape (ii) est chauffé à une température propice à l'élimination du milieu solvant de la solution liquide de dopant.

Avantageusement, le procédé selon l'invention comprend en outre les étapes supplémentaires consistant à :

(ia) disposer de la valeur de ladite transmittance $T_{ini}$ de la couche de nanotubes de carbone considérée en étape (i) préliminairement à la réalisation de l'étape (ii) ;
(iia) mesurer la valeur de la transmittance $T_D$ de ladite couche de nanotubes de carbone dopée juste après l'étape dopage (ii) ; et
(iib) apprécier la quantité de dopants par comparaison de la transmittance $T_D$ à la transmittance $T_{ini}$, une valeur $T_D$ inférieure à une valeur $T_{ini}$ étant représentative d'un dopage effectif.

Les mesures de transmittance peuvent être réalisées par une mesure en ligne au moyen d'un laser visible ou proche infrarouge.

Avantageusement, le procédé selon l'invention comprend en outre consécutivement à l'étape de dopage (ii), et si présente de l'étape (iib), une étape (iii) de stabilisation de la concentration en sels ou complexes organométalliques de platine ou de palladium de degré d'oxydation +IV ou +II au niveau de la couche de nanotubes de carbone dopée.

Selon une variante de réalisation, l'étape (iii) consiste en une opération de stabilisation temporelle. Si besoin, cette stabilisation peut être accélérée par voie thermique. La mise en oeuvre d'une telle étape relève clairement des compétences de l'homme de l'art.

Avantageusement, le procédé selon l'invention comprend, en outre, consécutivement à l'étape de dopage (ii), et si présente de l'étape (iii) de stabilisation telle que définie précédemment, au moins une étape (iv) consistant à transférer, par voie sèche ou par voie humide, une couche de graphène non dopée, notamment possédant une transmittance au moins égale à 97%, notamment dans le domaine du visible, en surface de la couche de nanotubes de carbone dopée obtenue à l'issue de l'étape (ii).

De préférence, le procédé comprend consécutivement à l'étape (iii) ou (iv) une mesure de la valeur de la transmittance $T_\infty$ de ladite couche de nanotubes de carbone dopés et stabilisés sur laquelle une couche de graphène a été empilée.

Selon une variante de réalisation de l'invention, le dopant est le $PtCl_4$. Toujours selon cette variante, la couche de nanotubes de carbone dopés et stabilisés correspondante possède, une résistance carrée stabilisée, $R\square\infty$ inférieure ou égale à 350 $\Omega/\square$, et de préférence inférieure ou égale à 300 $\Omega/\square$, voire inférieure ou égale à 100 $\Omega$ et avantageusement une transmittance T supérieure à 80% sur l'ensemble du spectre du visible.

Selon un autre aspect, la présente invention a trait à un matériau comprenant au moins une couche de nanotubes de carbone dopés obtenu par le procédé tel que défini selon l'invention.

Selon encore un autre aspect, la présente invention concerne l'utilisation d'une couche de nanotubes de carbone dopée obtenue par le procédé tel que défini selon l'invention pour fabriquer des écrans ultrafins et flexibles, des écrans tactiles, des batteries, des cellules solaires, des biocapteurs, des dispositifs électroniques ou opto-électroniques dans le domaine du visible ou de l'infra-rouge, des dispositifs spintroniques, des électrodes transparentes conductrices destinées à être incorporées dans des dispositifs de visualisation tel que des afficheurs, des écrans d'affichage, des écrans plats, et des diodes électroluminescentes organiques (OLED), dans des dispositifs photovoltaïques ou dans des interconnexions à base de nanotubes de carbone ou dans des câbles électriques à base de nanotubes.

Selon encore un autre aspect, la présente invention a pour objet un dispositif, en particulier tel que listé ci-dessus, comprenant une couche de nanotubes de carbone dopés obtenue par le procédé tel que défini selon l'invention ou un matériau tel que défini selon l'invention.

## I- PROCEDE DE DOPAGE SELON L'INVENTION

Comme il ressort de ce qui précède, le procédé permet d'augmenter significativement et de manière stabilisée la conductivité électrique d'une couche de nanotubes de carbone, notamment transparente, le cas échéant tout en permettant à celle-ci de conserver des propriétés de transmittance avantageuses.

Pour se faire, ce procédé met en oeuvre une technique de dopage chimique par transfert de charge impliquant d'une part, le choix d'un agent dopant particulier, d'autre part, le choix d'un mode de dopage spécifique, et enfin l'ajustement d'une concentration spécifique en dopants au niveau de la couche de nanotubes de carbone dopés.

### a) Couche de nanotubes de carbone à doper

Comme précisé ci-dessus, cette couche de nanotubes de carbone est avantageusement transparente.

Au sens de l'invention, l'expression transparence ou transmittance n'est pas limitée au domaine du visible. Elle peut également caractériser une transparence dans le domaine de l'infra-rouge.

Toutefois, selon une variante préférée, cette transparence caractérise une transparence sur l'ensemble du domaine du visible.

Plus précisément, la zone de nanotubes de carbone dopés selon l'invention possède avantageusement une transmittance sur l'ensemble du spectre du visible au moins égal à 80%.

Il est rappelé que la transmittance d'une structure donnée représente l'intensité lumineuse traversant la structure sur le spectre du visible.

Elle peut être mesurée par spectrométrie UV-Visible, par exemple à l'aide d'une sphère d'intégration sur un spectromètre de type Varian Carry.

La transmittance sur le spectre du visible correspond à la transmittance pour des longueurs d'ondes comprise entre 350 nm et 800 nm.

Toutes les méthodes décrites précédemment pour le dépôt de nanotubes de carbone peuvent être utilisées pour réaliser la couche de nanotubes de carbone considérée en étape (i).

La couche de nanotubes de carbone considérée en étape (i) est avantageusement supportée par un substrat.

De manière générale, dans le cadre de la présente invention, le terme « substrat » fait référence à une structure de base solide sur une des faces de laquelle est déposée au moins une couche de nanotubes de carbone.

Le substrat peut être de diverses natures.

Il peut s'agir d'un substrat flexible ou rigide.

Le substrat peut être transparent, translucide, opaque ou coloré. Il peut également s'agir d'un substrat temporaire tel qu'énoncé ci-dessus.

Toutefois, dans le cas où la couche de nanotubes de carbone dopés selon l'invention est destinée à une mise en oeuvre dans un dispositif devant satisfaire à des propriétés optiques de transparence, par exemple pour un écran tactile ou un dispositif de visualisation, etc, ce substrat cible est avantageusement formé à partir d'un matériau transparent.

Ce substrat peut être ainsi un substrat en verre ou en polymères transparents tels que le polycarbonate, les polyoléfines, le polyéthersulfone, le polysulfone, les résines phénoliques, les résines époxy, les résines polyesters, les résines polyimides, les résines polyétheresters, les résines polyétheramides, le polyvinyl(acétate), le nitrate de cellulose, l'acétate de cellulose, le polystyrène, les polyuréthanes, le polyacrylonitrile, le polytétrafluoroéthylène, les polyacrylates tels que le polyméthacrylate de méthyle, le polyarylate, les polyétherimides, les polyéthers cétones, les polyéthers éthers cétones, le polyfluorure de vinylidène, les polyesters tels que le polyéthylène téréphtalate ou polyéthylène naphtalate, le polydiméthylsiloxane, les polyamides, la zircone, ou leurs dérivés, ou encore du silicium recouvert d'une couche de nitrure ou d'une couche d'oxyde tel que par exemple $SiO_x$, ou $Al_2O_x$.

Selon une première variante, la couche de nanotubes de carbone considérée en étape (i) est directement supportée par un substrat.

Ainsi, selon un mode de réalisation préféré, les nanotubes de carbone à doper de l'étape (i) du procédé selon l'invention sont une couche disposée en surface et directement au contact d'un substrat constitué d'un matériau choisi parmi le verre, polyéthylène téréphtalate (PET), polycarbonate (PC), polyimide (PI), polyéthylène naphtalate (PEN), polydiméthylsiloxane (PDMS), polystyrène (PS), polyether sulfone (PES) ou du silicium recouvert d'une couche d'oxyde telle que $SiO_x$ ou $Al_2O_x$, et de préférence est choisi parmi du verre et du polyéthylène téréphtalate (PET).

### b) Solution liquide de dopants

Comme exposé ci-dessus, le procédé selon l'invention met en oeuvre, à titre de dopant, au moins un sel ou un complexe organométallique de platine ou de palladium de degré d'oxydation +IV ou +II.

Comme il ressort des exemples ci-après, les inventeurs ont, contre toute attente, constaté que les dopants considérés selon l'invention sont déterminants pour obtenir une amélioration de la conductivité électrique des nanotubes de carbone stabilisés temporellement en termes d'efficacité.

Sans vouloir être liée par la théorie, cette stabilisation progressive au dopage est vraisemblablement associée à une réorganisation chimique et morphologique des espèces dopantes à la surface de la couche de nanotubes de carbone.

De manière avantageuse, les sels ou complexes organométalliques de platine ou de palladium de degré d'oxydation +IV ou +II convenant à l'invention conduisent à des arrangements bidimensionnels, potentiellement responsables du phénomène de stabilité, à la surface des nanotubes de carbone. Il est par ailleurs à noter que si les nanotubes sont ouverts, le dopant rentre à l'intérieur des tubes. A l'inverse, les sels d'Au se réarrangent à la surface de la couche de nanotubes de carbone pour former des particules 3D métalliques de tailles pouvant être microniques, ce qui crée en outre des rugosités nuisibles à la fabrication de dispositifs à base d'électrodes transparentes (créations de courts-circuits entre les couches...).

Avantageusement et contrairement à ce qui est classiquement observé pour d'autres solutions de sels métalliques et notamment d'Au, le dopage reste actif après un vieillissement temporel de l'échantillon. Les sels ou complexes organométalliques de platine ou de palladium de degré d'oxydation +IV ou +II convenant à l'invention s'avèrent ainsi particulièrement avantageux comparativement à, par exemple, des sels d'Au. En effet, ils permettent d'assurer une efficacité de dopage stable dans le temps, contrairement à un sel d'Au qui se transforme progressivement en métal d'or et conduit à une perte de l'effet dopant. Le dopage de type p induit par l'utilisation des sels conformes à l'invention conduit à une amélioration de la conductivité électrique des nanotubes stable dans le temps dans les conditions ambiantes (air, humidité...) à partir d'un temps caractéristique compris entre 30 et 60 jours qui dépend des conditions de dépôt.et en température, en particulier jusqu'à une température de l'ordre de 200°C. Par exemple, les inventeurs ont observé que les spectres XPS en température montrent que la réduction du $PtCl_4$ en platine métal n'intervient qu'au-delà de 250°C.

Contrairement à ce qui est classiquement observé pour d'autres solutions de sels métalliques, le dopage reste actif après un vieillissement temporel et/ou thermique de l'échantillon car la formation de particules métalliques non décorée par du chlore n'apparait qu'a température élevée Les espèces chlorées sont beaucoup plus efficaces que les particules métalliques: après stabilisation, on conserve une résistance carré ($R\square\infty$) inférieure à la résistance initiale avant dopage.

Plus particulièrement, à titre de dopants conformes à l'invention, on peut notamment citer :

- les sels de platine ou de palladium de formules :
  $A_2MX_6$, $MX_4$, $A_2MX_4$ et $MX_2$
  dans lesquelles :

  - A est un atome d'hydrogène, un groupe $NH_4$, un atome de sodium, un atome de lithium ou un atome de potassium ;

  - X est un atome de fluor, un atome de chlore, un atome de brome ou un atome d'iode ; et

  - M est un atome de platine ou un atome de palladium de degré d'oxydation +IV ou +II.

    - les complexes organométalliques de platine ou de palladium tel que par exemple le $Pt(CH_3)_3I$ ; et
    - leurs mélanges.

Selon un mode de réalisation préféré, le dopant est un sel ou complexe organométallique de platine ou de palladium de degré d'oxydation +IV ou +II de formules telles que définies ci-dessus est de préférence le sel de $PtCl_4$.

Comme exposé ci-dessus, le dopage de la couche de nanotubes de carbone à l'aide d'un ou plusieurs dopants conformes à l'invention, est réalisé par pulvérisation d'une solution liquide véhiculant ledit dopant. Dans la présente invention, cette solution liquide peut être nommée indifféremment « solution liquide de dopants » ou « solution de dopage ».

Pour des raisons évidentes, le milieu solvant composant la solution liquide de dopage est choisi de manière appropriée au regard de la nature du ou desdits dopants.

Conviennent tout particulièrement à la solution de dopage conforme à l'invention, des milieux solvants polaires qui permettent la dissolution des dopants inorganiques.

On peut citer notamment le nitrométhane, l'acétonitrile, l'acétone, la méthyléthylcétone, le diéthyl ether, le tetrahydrofurane, le dichlorométhane, le chloroforme et autres solvants chlorés, le benzonitrile, un solvant de type alcool, en particulier les monoalcools ayant de 1 à 5 atomes de carbone.

Selon un mode de réalisation préféré, le solvant est le nitrométhane.

Par ailleurs, des solvants à plus haut point d'ébullition comme la N-méthylpyrrolidone, la N-éthylpyrrolidone, le diméthylsulfoxide, l'éthylene glycol peuvent être utilisés et conduire à des performances similaires.

Ainsi, selon un mode de réalisation particulier, la solution liquide de dopant convenant à l'invention peut comprendre un solvant choisi parmi le nitrométhane, l'acétonitrile, l'acétone, la méthyléthylcétone, le diéthyl ether, le tetrahydrofurane, le dichlorométhane, le chloroforme et autres solvants chlorés, le benzonitrile, un solvant de type alcool, en particulier les monoalcools ayant de 1 à 5 atomes de carbone, la N-méthylpyrrolidone, la N-éthylpyrrolidone, le diméthylsulfoxide, l'éthylene glycol, et leurs mélanges, de préférence le nitrométhane.

Selon un mode de réalisation particulièrement préféré, la solution de dopage comprend du $PtCl_4$ en solution dans du nitrométhane.

D'une manière générale, la concentration de la solution de dopage convenant à l'invention est inférieure à 5mM et préférence varie de 0,1 mM à 3mM notamment dans le cas où le dopant considéré selon l'invention est le PtCl$_4$.

### c) Technique de dépôt par pulvérisation

Comme évoqué précédemment, dans un procédé selon l'invention, la solution de dopage est mise en contact, lors de l'étape (ii) sur au moins une zone voire toute la surface de la couche de nanotubes de carbone à doper, par pulvérisation de préférence au travers d'une buse.

En effet, les inventeurs ont constaté que contrairement aux autres techniques de dépôt et notamment la technique de dépôt par trempage, l'utilisation d'une technique de dépôt par pulvérisation permet d'augmenter sans limitation physique la quantité de dopants déposés à la surface de la couche de nanotubes de carbone.

En d'autres termes, la combinaison de la pulvérisation à titre de technique de dopage avec la nature chimique de dopant requise selon l'invention permet d'atteindre après stabilisation, une efficacité de dopage nettement meilleure par rapport aux techniques communes de dépôt des dopants.

La technique de dépôt de PtCl$_4$ par pulvérisation manuelle conformément à l'invention permet avantageusement d'obtenir des nanotubes de carbone dopés dont la résistance carrée après dopage est très inférieure à celle obtenue pour des nanotubes de carbone dopés par une technique d'immersion.

Par ailleurs, la technique de dépôt par pulvérisation s'avère particulièrement efficace en termes de rendement (exprimé par le rapport pondéral de la quantité de dopants déposés à la surface de la couche de nanotubes de carbone sur la quantité de dopants dans la solution de dopage initiale), par rapport aux autres techniques de dépôt. Ainsi, contrairement aux techniques de dépôt par immersion ou « spin-coating », un rendement proche de 100 %, sans perte de métal précieux, est effectivement possible, ce qui constitue un avantage économique certain.

De préférence, la pulvérisation selon l'invention consiste à nébuliser en un brouillard de fines gouttelettes la solution liquide de dopant(s) sur au moins une zone voire toute la surface de la couche de nanotubes de carbone à doper.

La pulvérisation peut être réalisée en mode continu ou manuel.

Selon une première variante, les dopants peuvent être déposés à la surface des nanotubes de carbone par pulvérisation automatique. Cette pulvérisation peut être réalisée au moyen d'une buse soumise à des vibrations ultrasoniques, par exemple au moyen d'un équipement industriel commercialisé par la société SONO-TEK.

Selon une deuxième variante, les dopants peuvent être déposés à la surface des nanotubes de carbone par pulvérisation manuelle. Cette pulvérisation peut être réalisée au moyen d'une buse, notamment à l'aide d'un aérographe manuel AZTEK, par exemple de diamètre de 0,7 mm.

La couche de nanotubes de carbone destinée à être dopée est orientée face à la buse et généralement placée à une distance contrôlée par rapport à la sortie de la buse.

Comme détaillé ci-après, la buse peut être fixe ou mobile de même que l'entité substrat/couche de nanotubes de carbone à doper.

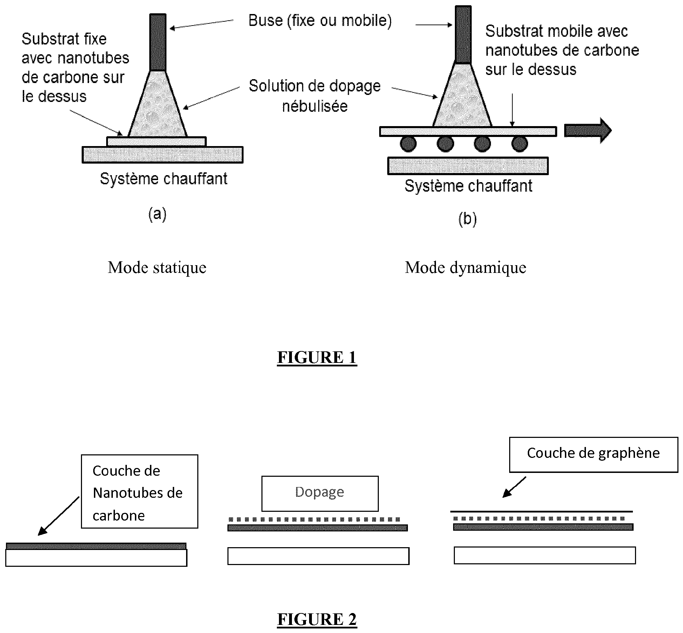

Le mode de réalisation où l'entité substrat/ couche de nanotubes de carbone à doper est fixe est en particulier illustré en figure 1 (a).

Le mode de réalisation où l'entité substrat/ couche de nanotubes de carbone à doper est mobile est illustré en figure 1 (b). Il est en particulier représentatif d'une technique de dopage au défilé selon un procédé « roll-to-roll ».

Dans cette variante de réalisation, la buse mobile utilisée est avantageusement une buse soumise à des vibrations ultrasoniques et dont la fréquence est d'autant plus élevée qu'il est recherché des gouttelettes de taille réduite.

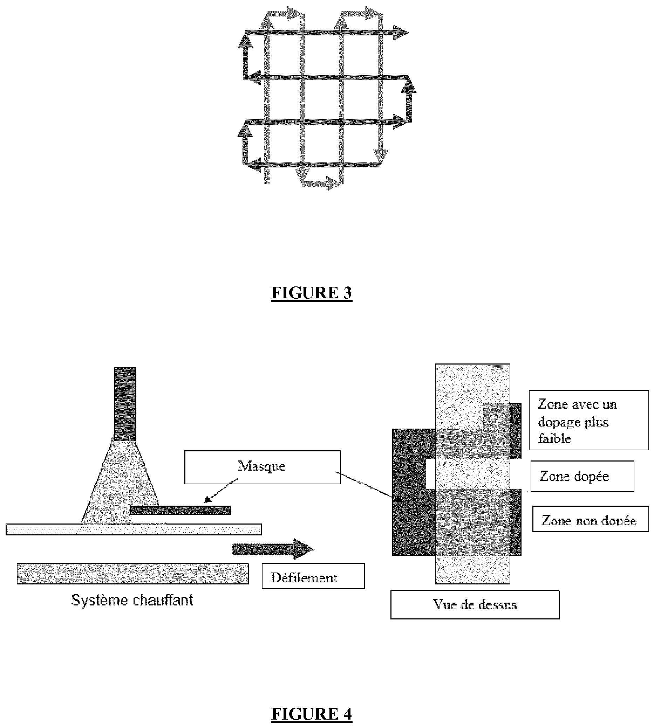

Cette buse mobile peut se déplacer de telle sorte, par exemple selon un chemin croisé qui permet de favoriser l'homogénéité du dépôt de dopants. En effectuant plusieurs passages croisés, plusieurs dépôts consécutifs de dopants peuvent ainsi être superposés sur la même zone de la couche de nanotubes de carbone à doper afin de maximiser la quantité de dopants à la surface de la couche de nanotubes de carbone. La figure 3 illustre par exemple un mode de balayage croisé de spray pour réaliser une couche de dopant.

La durée de la pulvérisation au niveau de la zone traitée ou de toute la surface de la couche de nanotubes de carbone à doper, est donc variable. Comme évoqué précédemment, l'utilisation de différentes durées pour la pulvérisation permet, au même titre que l'utilisation de solutions de dopants à différentes concentrations, d'ajuster la quantité de dopants déposée au niveau de la couche de nanotubes de carbone à doper.

Selon un mode de réalisation particulier, le substrat supportant la couche de nanotubes de carbone peut être disposé à proximité immédiate voire au contact d'un système chauffant tel qu'un support chauffant ou une plaque chauffante portée à une température efficace pour l'élimination du milieu liquide véhiculant le ou les dopants conformes à l'invention.

Selon un autre mode de réalisation particulier, la solution liquide de dopant(s) peut être pulvérisée au travers d'un masque mécanique, par exemple un masque pochoir, de manière à ne doper qu'une zone de la couche de nanotubes de carbone à traiter.

Le masque, intercalé entre la buse et le substrat, est fixe et disposé légèrement au-dessus de la couche de nanotubes de carbone à doper pour ne pas l'endommager. Il n'y a pas de contact direct entre la couche et le masque. Après dopage et stabilisation (temporelle ou en température), la couche de nanotubes de carbone dopée ainsi obtenue comporte des zones non dopées et des zones dopées délimitées selon le motif du masque. Il s'ensuit que les zones dopées sont dotées d'une conductivité électrique supérieure à celle des zones de nanotubes de carbone non dopées. La technique de dépôt des dopants par pulvérisation au travers d'un masque mécanique permet ainsi la localisation des dopants dans des zones définies à la surface de la couche de nanotubes de carbone.

Cette variabilité contrôlée de concentration en dopants sur une surface de nanotubes de carbone peut également être avantageusement ajustée *via* le contrôle de la pulvérisation en surface de la couche de nanotubes de carbone à travers la mobilité de la buse de pulvérisation et/ou de l'ensemble substrat/couche de nanotubes de carbone.

Selon un mode de réalisation préféré, l'ensemble substrat/couche de nanotubes de carbone est fixe et la buse est mobile.

Selon un autre mode de réalisation préféré, la buse est fixe et l'ensemble substrat/couche de nanotubes de carbone est mobile et défile selon un procédé « roll-to-roll ». Des bandes correspondant à différents taux de dopage peuvent donc ainsi être créées. Pour une vitesse de défilement donnée, la quantité de dopants déposée dans les différentes zones dépend des dimensions des ouvertures. Un procédé de type « roll-to-roll » permet de créer des zones de conductivité électrique distinctes par le choix de différents taux de dopage ou gradients de dopage sur l'ensemble substrat/couche de nanotubes de carbone qui défile.

Avantageusement, ce mode permet d'alterner zones dopées et zones non dopées, ou d'alterner des zones avec différentes efficacités de dopage.

**d) Ajustement de la quantité de dopants au niveau de la couche de nanotubes de carbone obtenue selon l'invention**

Comme précisé ci-dessus, l'invention découle plus particulièrement de l'observation par les inventeurs qu'il s'avère possible, grâce aux choix de la technique de dépôt et de la nature de dopant, d'obtenir une couche de nanotubes de carbone dopés avec un excès de dopant et que cet excès en dopants, s'avère déterminant pour accéder à une efficacité de dopage avantageusement stabilisée au cours du vieillissement de la zone de nanotubes de carbone dopée.

De manière inattendue, le dopage d'un excès de dopants permet de conférer à la zone de la couche de nanotubes de carbone traitée, certes une valeur de résistance carré juste après dopage, R□D, significativement diminuée par rapport à la valeur de résistance carré native R□ini mais surtout une valeur de résistance carré stabilisée R□∞, demeurant significativement inférieure à R□ini. Ce gain en efficacité avantageusement stabilisé dans le temps est en outre obtenu pour un bon niveau de de transmittance.

Ainsi, la mise en oeuvre d'une technique de dépôt différente de la pulvérisation, telle que le trempage ne convient pas pour obtenir cet excès en dopant(s). Lors du trempage, la surface de la couche de nanotubes de carbone est en équilibre avec la solution de dopage et ne peut être augmentée arbitrairement. En effet, la solubilité du réactif de dopage dans le solvant n'est pas infinie et l'équilibre entre la solution et la surface des nanotubes de carbone limite la quantité de dopants adsorbée.

En revanche, la technique de dépôt par pulvérisation ou spray considérée selon l'invention permet d'accéder à un dopage en excès de dopant Q qui contre toute attente conditionne une valeur de résistance carrée R□∞, efficace. En particulier, la quantité de dopant Q déposée sur la surface joue un rôle important sur l'efficacité de dopage. Cette efficacité n'est pas linéaire. La quantité de dopant peut être optimisée suivant l'application, et notamment en fonction du degré de transparence recherché.

Avantageusement, la valeur de R□∞ est d'autant plus faible et proche de la valeur de la résistance carrée juste après dopage R□(D), que la quantité de dopants en excès est élevée.

Plus préférentiellement, la quantité en dopant est avantageusement ajustée de manière à obtenir une résistance carrée stabilisée des zones dopées de la couche de nanotubes de carbone inférieure ou égale à 350 ohm/carré et une transmittance sur l'ensemble du spectre visible d'au moins 80 %.

De même, la quantité en dopant est avantageusement efficace pour procurer à ladite zone de nanotubes de carbone dopée une résistance carrée R□∞ dont la valeur correspond à une diminution d'au moins 10%, de préférence d'au moins 40% voire d'au moins 80% de la valeur de R□ini, tout en conservant une valeur de transmittance supérieure à 80% sur l'ensemble du spectre du visible.

Le contrôle de l'ajustement de la quantité Q en dopant, peut avantageusement être réalisé par mesure de la transmittance de la zone de la couche de nanotubes de carbone traitée à une longueur d'onde donnée, notamment à 550 nm.

Cette transmittance à 550 nm peut être mesurée au moyen d'un spectromètre UV-visible. Il est également possible de considérer une mesure en ligne au moyen d'un laser visible (HeNe, diode laser) ou proche infrarouge.

Ainsi, selon un mode de réalisation particulier, le procédé selon l'invention contrôle l'ajustement de la quantité en dopants Q au niveau de la zone de la couche de nanotubes de carbone traitée selon l'invention par mesure de la transmittance dans le domaine du visible de la couche de carbone de l'étape (ii).

Selon une variante préférée, ce contrôle est réalisé par comparaison de ladite mesure de transmittance obtenue à l'issue du dopage, de préférence le jour du dopage ou 1 à 2 jours après, à une mesure de transmittance de référence obtenue au préalable sur la couche de nanotubes de carbone de l'étape (i).

Cette transmittance est d'autant plus faible que la quantité de dopants est élevée.

Ainsi la présente invention vise également la variante de procédé comprenant au moins les étapes consistant à :

(ia) mesurer la valeur de ladite transmittance $T_{ini}$ de la couche de nanotubes de carbone considérée en étape (i) préliminairement à la réalisation de l'étape (ii) ;

(iia) mesurer la valeur de la transmittance $T_D$ de ladite couche de nanotubes de carbone dopée juste après l'étape dopage (ii) ; et

(iib) apprécier la quantité de dopants, et donc en particulier l'efficacité du dopage, par comparaison de la transmittance $T_D$ à la transmittance $T_{ini}$, une valeur $T_D$ inférieure à une valeur $T_{ini}$ étant représentative d'un dopage effectif.

Dans l'hypothèse où aucune différence significative n'est observée entre les valeurs $T_D$ et $T_{ini}$, le dopage de l'étape (ii) est poursuivi ou reproduit avec le cas échéant un ajustement des conditions de pulvérisation et/ou de la concentration en dopants de la solution liquide de dopants.

De manière avantageuse, la quantité de dopant et les conditions de dépôt peuvent être ainsi ajustées et optimisées en fonction de la valeur de la transmittance optique.

Avantageusement, le procédé selon l'invention comprend en outre consécutivement à l'étape de dopage (ii) une étape (iii) visant à stabiliser les dopants au niveau de la couche de nanotubes de carbone.

Cette étape (iii) est une étape de stabilisation temporelle, qui peut être éventuellement accélérée par voie thermique.

Dans cette variante de réalisation, un moyen de stabilisation des dopants à la surface de la couche de nanotubes de carbone consiste à recuire l'échantillon à une température donnée induisant ainsi un « vieillissement » accéléré. Cette température est fonction du sel utilisé et de la quantité de dopants à la surface des nanotubes de carbone. Elle peut typiquement être supérieure ou égale à la température utilisée lors de l'étape de spray du dopant et inférieure à 300°C.

Toujours dans cette variante de réalisation, le procédé selon l'invention peut avantageusement comprendre une étape (iiia) consistant à mesurer la valeur de la transmittance $T_\infty$ de ladite couche de nanotubes de carbone dopée et stabilisée, et consécutivement, une étape (iiib) consistant à apprécier l'efficacité du dopage par comparaison de la transmittance $T_\infty$ à la transmittance $T_{ini}$, une valeur $T_\infty$ inférieure à une valeur $T_{ini}$ étant représentative d'un dopage effectif conservé après stabilisation.

Avantageusement, le procédé selon l'invention peut comprendre en outre consécutivement à l'étape de dopage (ii), et si présente de l'étape (iii) de stabilisation telle que définie précédemment, au moins une étape (iv) consistant à transférer, par voie sèche ou par voie humide, une couche de graphène de préférence transparente, en surface de la couche de nanotubes de carbone dopée obtenue à l'issue de l'étape (ii).

En effet, les dopants sont relativement stables vis-à-vis des technologies permettant l'empilement de couches de graphène. La figure 2 correspond à un tel empilement où la couche de nanotubes dopée est encapsulée par une couche de graphène.

Cette seconde variante de réalisation constitue une alternative particulièrement intéressante à la stabilisation temporelle ou par voie thermique précitée, en ce qu'elle permet de fournir une stabilité accrue notamment en chaleur humide.

Selon cette variante, on peut ainsi réaliser un système composé d'un substrat de la couche de nanotubes de carbone dopée et encapsulé par une couche de graphène (CVD ou couche déposée par spray). Les dopants sont alors efficaces à la fois pour les tubes et pour la couche de graphène.

## II- COUCHE DE NANOTUBES DE CARBONE DOPEE OBTENU SELON L'INVENTION ET SES APPLICATIONS

Comme énoncé ci-dessus, la couche de nanotubes de carbone dopée selon le procédé de l'invention est caractérisée par une valeur de résistance carrée $R\square\infty$.

La résistance carrée $R\square\infty$ de la couche de nanotubes de carbone dopée selon l'invention est significativement inférieure à la résistance carrée de la zone de nanotubes de carbone non dopée, à savoir $R\square ini$, notamment d'au moins 10%, de préférence d'au moins 30% voire d'au moins 50% par rapport à la valeur de $R\square ini$.

La valeur de cette résistance carrée stabilisée $R\square\infty$ peut être égale à la valeur de la résistance $R\square D$. Généralement, elle est comprise entre la valeur $R\square ini$ et la valeur de résistance carrée obtenue juste après dopage $R\square D$.

Une résistance carrée d'une couche de nanotubes de carbone dopée considérée selon l'invention peut être caractérisée comme étant conforme à la résistance carrée stabilisée $R\square\infty$ requise selon l'invention à partir du moment où il n'est constaté aucune variation ou augmentation de plus de 8% de sa valeur au cours du temps.

Des tests peuvent le cas échéant être mis en oeuvre pour la caractériser. Par exemple un test de « vieillissement » sur une durée pouvant aller jusqu'à 50 jours voire plus ou même moins, à température ambiante (20 °C +/- 3 °C) et pression atmosphérique, à compter du dopage. Un autre test, plus rapide en termes de durée, peut consister à imposer un recuit à une température comprise entre 100 °C et 200°C juste après dopage de la couche de nanotubes de carbone dopée. L'alternative de stabilisation en température permet d'induire un « vieillissement » accéléré, pour atteindre plus rapidement une valeur de R□ stable dans le temps et figurée par R□∞. Bien entendu, cette température est fonction du sel utilisé et de la quantité de dopants à la surface des nanotubes de carbone. Ces ajustements de mesure relèvent clairement des compétences de l'homme de l'art. Typiquement, elle est supérieure ou égale à la température utilisée lors de l'étape de pulvérisation du dopant et inférieure à 200°C.

Selon un autre aspect, la présente invention concerne un matériau comprenant des nanotubes de carbone dopés obtenus par le procédé tel que défini précédemment. Un tel matériau possède des propriétés intéressantes en termes de conductivité électrique et de transparence.

Des nanotubes de carbone dopés *via* le procédé selon l'invention peuvent être utilisés pour de nombreuses applications : écrans ultrafins et flexibles, écrans tactiles, batteries, cellules solaires, électronique, opto-électronique, spintronique, biocapteurs, traitement de la pollution, etc.

En outre, ces nanotubes de carbone dopés offrent une alternative intéressante pour la réalisation d'électrodes transparentes et conductrices qui sont comprises dans des dispositifs de visualisation (afficheurs, écrans plats, diodes électroluminescentes organiques (OLED)), des dispositifs photovoltaïques, des dispositifs électroniques à base de nanotubes de carbone ou des interconnexions à base de nanotubes de carbone ou des câbles électriques à base de nanotubes de carbone.

Bien entendu, l'invention n'est pas limitée aux modes de réalisations décrits ci-dessus.

L'invention va maintenant être décrite au moyen des exemples et figures suivants, donnés à titre illustratif et non limitatif de l'invention.

## FIGURES

Figure 1 : Illustration schématique d'un dépôt par pulvérisation sur un substrat fixe (a) (mode statique), ou sur un substrat mobile (b) (mode dynamique) pour un procédé de dopage au défilé de type « roll-to-roll ».

Figures 2 : Illustration d'un mode de réalisation permettant l'obtention d'un système encapsulé d'une couche de nanotubes de carbone avec une couche de graphène.

Figure 3 : Illustration du balayage d'un spray réalisé correspondant à une couche de dopant.

Figure 4 : Illustration d'un dopage à l'aide d'un masque (exemple 4)

Il convient de noter que, pour des raisons de clarté, les différents éléments visibles sur les figures sont représentés en échelle libre, les dimensions réelles des différentes parties n'étant pas respectées.

## EXEMPLES

Les abréviations suivantes ont été utilisées :

| | |
|---|---|
| R□ : | Résistance carrée |
| R□ini : | Résistance carrée initiale, c'est-à-dire résistance carrée avant dopage |
| R□D : | Résistance carrée D, c'est-à-dire résistance carrée juste après dopage |
| Ω/□ : | Ohm/carré |

Méthodes de mesure

La résistance carrée de la couche des nanotubes de carbones est mesurée sur l'ensemble de la surface de l'échantillon selon une technique de mesure 4 pointes par effet Hall avec une géométrie de type Van der Pauw, à l'aide d'un équipement Ecopia HMS-3000, pour un courant compris entre -100 et +100 μA

La transmittance, T, est mesurée à 550 nm au moyen d'un spectromètre UV-visible-proche infra-rouge de type Agilent cary 5000. T représente le rapport des transmittances entre l'échantillon à caractériser et constitué d'un substrat transparent recouvert d'une ou plusieurs mono-couches de nanotubes de carbone dopées ou non dopées et un échantillon de référence correspondant à un substrat nu de nature identique.

**Exemple 1** : **Nanotubes de carbone en mono-couche dopée au moyen d'une pulvérisation automatique type SONO-TEK (substrat fixe et buse mobile)**

**(i) Echantillon 1** :

Le substrat est un substrat en polymère dont les dimensions sont $2,5 \times 2,5$ cm$^2$ sur le lequel est déposé une couche de nanotubes de carbone obtenue par la technique du catalyseur flottant.

**(ii) Solution de dopage** :

La solution de dopage est formée de sel de PtCl$_4$ solide dissous dans le nitrométhane. La concentration de la solution est de 1 mM.

**(iii) Conditions de dépôt des dopants** :

Les dopants sont déposés à la surface des nanotubes de carbone par pulvérisation (ou « spray ») automatique au moyen d'une buse soumise à des vibrations ultrasoniques *via* un équipement industriel commercialisé par la société SONO-TEK. La buse placée au-dessus du substrat, à une distance de 10 cm, se déplace au-dessus de l'échantillon à doper, qui est fixe et posé sur un support chauffant à 110 °C. La pulvérisation est créée par la buse au moyen d'un système ultrason, à la fréquence de 48 kHz. La solution est injectée dans la buse à la vitesse de 0,75 mL/min. La buse se déplace au-dessus de l'échantillon en balayant un chemin au pas de 5 mm, correspondant à un passage croisé, ceci pour favoriser l'homogénéité du dépôt. 8 « couches » de dopants sont superposées sur le même échantillon pour maximiser la quantité de dopants à la surface des nanotubes de carbone, en effectuant plusieurs passages croisés sur le même échantillon à l'image de la figure 3. La vitesse de balayage est de 50 mm/s.

Résultats : R□uini avant dopage est mesuré à 315 Ohm et après dopage R□D à 82 Ohm.

Une amélioration de la conductivité d'un facteur 3,8 est ainsi observée.

L'utilisation de solutions de différentes concentration et l'utilisation de différentes durées d'exposition au spray permet de faire varier la quantité de dopants déposés à la surface des nanotubes de carbone Avantageusement on utilise les solutions les moins concentrées qui permettent une meilleure homogénéité.

**Exemple 2 : Nanotubes de carbone en mono-couche dopée au moyen d'une pulvérisation automatique type SONO-TEK (substrat fixe et buse mobile)**

Selon la même procédure qu'à l'exemple 1, on réalise une monocouche de nanotubes de carbone.

Toutefois, à la différence de l'exemple 1, on procède uniquement à 2 passages pour la formation de l'empilement.

Résultats : R□uini avant dopage est mesuré à 292 Ohm et après dopage à R□D 88 Ohm.

**Exemple 3 (comparatif) : Nanotubes de carbone sur substrat de silicium dopés par trempage**

Des lignes de nanotubes individuels sont déposés sur un substrat de silicium. A partir de la croissance de tubes individuel dans des via.

La résistance linéique des nanotubes avant dopage est mesurée à 200 kOhm/$\mu$m.

Un dopage est mis en oeuvre par technique classique de trempage pendant 24heures dans une solution 2,5 mMol de PtCl$_4$ dans du nitrométhane.

La résistance linéique après dopage a été mesurée à 120 kOhm/$\mu$m.

On constate que l'efficacité de dopage par trempage est bien moindre qu'en utilisant le procédé selon la présente invention.

**Exemple 4 : Dépôt à travers un masque**

Un dépôt est réalisé selon les mêmes conditions que l'exemple 1 à l'exception de l'utilisation d'un masque qui permet de moduler la quantité de dopage en fonction de zones déterminées. Un masque (pochoir) est ainsi positionné à quelques mm de la surface de l'échantillon. La figure 4 illustre la réalisation de cet exemple.

Sur l'échantillon obtenu, on mesure, au niveau de la zone dopée un Ω/□ à 80 Ohm/carré alors que pour la zone sous le masque, le Ω/□ s'élève à 300 Ohm/carré.

**Revendications**

1. Procédé utile pour préparer une couche de nanotubes de carbone, en particulier transparente, et de conductivité électrique améliorée et stabilisée, ledit procédé comprenant au moins les étapes consistant à :

   (i) disposer d'au moins une couche de nanotubes de carbone, en particulier transparente, possédant une résistance carrée, R□ini,
   (ii) doper au moins une zone de ladite couche de nanotubes de carbone pour former une zone de nanotubes de carbone dopée ayant une résistance carrée stabilisée, R□∞, de valeur inférieure à R□ini.

   **caractérisé en ce que** l'étape (ii) est réalisée par pulvérisation, en surface d'au moins ladite zone de ladite couche de nanotubes de carbone (i), d'au moins un dopant choisi parmi les sels et complexes organométalliques de platine ou de palladium de degré d'oxydation +IV ou +II.

2. Procédé selon la revendication précédente, **caractérisé en ce que** la valeur de la résistance carrée stabilisée, R□∞, est comprise entre la valeur R□ini et la valeur de résistance carrée obtenue juste après dopage R□D.

3. Procédé selon l'une quelconque des revendications précédentes, **caractérisé en ce que** la zone de nanotubes de carbone dopée possède une valeur de transmittance supérieure à 80%, sur l'ensemble du spectre du visible.

4. Procédé selon l'une quelconque des revendications précédentes, **caractérisé en ce que** la couche de nanotubes de carbone de l'étape (i) est supportée par un substrat, en particulier est directement au contact dudit substrat, ledit substrat étant plus particulièrement transparent ou translucide dans le domaine du visible ou de l'infra-rouge et de préférence choisi parmi le verre, polyéthylène téréphtalate, polycarbonate, polyimide, polyéthylène naphtalate, polydiméthylsiloxane, polystyrène, polyether sulfone ou du silicium recouvert d'une couche de nitrure ou d'une couche d'oxyde telle que SiOx, ou Al$_2$Ox, et de préférence est choisi parmi du verre et du polyéthylène téréphtalate.

**5.** Procédé selon l'une quelconque des revendications précédentes, **caractérisé en ce que** le dopant est choisi parmi :

- les sels de platine ou de palladium de formules :
$A_2MX_6$, $MX_4$, $A_2MX_4$ et $MX_2$
dans lesquelles :

- A est un atome d'hydrogène, un groupe $NH_4$, un atome de sodium, un atome de lithium ou un atome de potassium ;
- X est un atome de fluor, un atome de chlore, un atome de brome ou un atome d'iode ; et
- M est un atome de platine ou un atome de palladium de degré d'oxydation +IV ou +II ;

en particulier le dopant est choisi parmi les sels de $PtCl_4$, $H_2PtCl_6$, $H_2PtCl_4$, $PtCl_2$, $H_2PdCl_6$, $PdCl_2$, $K_2PdCl_4$ et leurs mélanges et est de préférence le $PtCl_4$.

**6.** Procédé selon l'une quelconque des revendications précédentes, **caractérisé en ce que** le dopant est mis en oeuvre au sein d'une solution liquide, ladite solution liquide de dopant étant plus particulièrement une solution de $PtCl_4$ à une concentration inférieure à 5mM et de préférence variant de 0,1 mM à 3 mM.

**7.** Procédé selon l'une quelconque des revendications précédentes, **caractérisé en ce que** l'opération de pulvérisation au niveau de ladite couche de nanotubes de carbone peut être réalisée en une fois ou répétée une à plusieurs fois.

**8.** Procédé selon l'une quelconque des revendications précédentes, **caractérisé en ce que** l'étape (ii) est réalisée en mode dynamique selon une technique de dopage au défilé et en particulier de type « roll-to-roll ».

**9.** Procédé selon l'une quelconque des revendications 4 à 8, **caractérisé en ce que** le substrat supportant la couche de nanotubes de carbone traitée en étape (ii) est chauffé à une température propice à l'élimination du milieu solvant de la solution liquide de dopant.

**10.** Procédé selon l'une quelconque des revendications précédentes, **caractérisé en ce qu'**il comprend en outre les étapes supplémentaires consistant à :

(ia) mesurer la valeur de ladite transmittance $T_{ini}$ de la couche de nanotubes de carbone considérée en étape (i) préliminairement à la réalisation de l'étape (ii) ;
(iia) mesurer la valeur de la transmittance $T_D$ de ladite couche de nanotubes de carbone dopée juste après l'étape dopage (ii) ; et
(iib) apprécier la quantité de dopants par comparaison de la transmittance $T_D$ à la transmittance $T_{ini}$, une valeur $T_D$ inférieure à une valeur $T_{ini}$ étant représentative d'un dopage effectif ;

les mesures de transmittance étant plus particulièrement réalisées par une mesure en ligne au moyen d'un laser visible ou proche infrarouge.

**11.** Procédé selon l'une quelconque des revendications précédentes, **caractérisé en ce qu'**il comprend en outre consécutivement à l'étape de dopage (ii), et si présente de l'étape (iib), une étape (iii) de stabilisation des sels ou complexes organométalliques de platine ou de palladium de degré d'oxydation +IV ou +II au niveau de la couche de nanotubes de carbone dopée, l'étape (iii) étant plus particulièrement une étape de stabilisation temporelle, qui peut être éventuellement accélérée par voie thermique.

**12.** Procédé selon l'une quelconque des revendications précédentes, **caractérisé en ce qu'**il comprend en outre consécutivement à l'étape de dopage (ii), et si présente de l'étape (iii) de stabilisation selon la revendication 11, au moins une étape (iv) consistant à transférer, de préférence par voie sèche, une couche de graphène non dopée, notamment possédant une transmittance au moins égale à 97%, notamment dans le domaine du visible, en surface de la couche de nanotubes de carbone dopée obtenue à l'issue de l'étape (ii).

**13.** Procédé selon l'une quelconque des revendications précédentes, **caractérisé en ce que** le dopant est le $PtCl_4$, et la zone de la couche de nanotubes de carbone dopée et stabilisée possède, une résistance carrée stabilisée, $R\square\infty$ inférieure ou égale à 350 Ω/□ et de préférence inférieure ou égale à 300 Ω/□ voire inférieure ou égale à 100 Ω/□ et une transmittance T supérieure à 80% sur l'ensemble du spectre du visible.

**14.** Matériau comprenant au moins une couche de nanotubes de carbone dopée obtenu par le procédé tel que défini selon l'une quelconque des revendications 1 à 13.

**15.** Utilisation d'une couche de nanotubes de carbone dopée obtenue par le procédé tel que défini selon l'une quelconque des revendications 1 à 13 ou d'un matériau tel que défini en revendication 14 pour fabriquer des écrans ultrafins et flexibles, des écrans tactiles, des batteries, des cellules solaires, des biocapteurs, des dispositifs électroniques ou opto-électroniques, des dispositifs spintroniques, des électrodes transparentes conductrices destinées à être incorporées dans des dispositifs de visualisation tel que des afficheurs, des écrans d'affichage, des écrans plats, et des diodes électroluminescentes organiques (OLED), dans des dispositifs photovoltaïques, dans des interconnexions à base de nanotubes de carbone ou dans des câbles électriques à base de nanotubes de carbone.

16. Dispositif comprenant une couche de nanotubes dopée obtenue par le procédé tel que défini selon l'une quelconque des revendications 1 à 13 ou un matériau tel que défini en revendication 14, ledit dispositif étant en particulier choisi parmi des écrans ultrafins et flexibles, des écrans tactiles, des batteries, des cellules solaires, des biocapteurs, des dispositifs électroniques ou opto-électroniques, des dispositifs spintroniques, des électrodes transparentes conductrices, des dispositifs de visualisation tel que des afficheurs, des écrans d'affichage, des écrans plats, et des diodes électroluminescentes organiques (OLED), des dispositifs photovoltaïques , des interconnexions à base de nanotubes de carbone et dans des câbles électriques à base de nanotubes de carbone.

Substrat fixe
avec nanotubes
de carbone sur
le dessus

Buse (fixe ou mobile)

Substrat mobile avec
nanotubes de carbone
sur le dessus

Solution de dopage
nébulisée

Système chauffant

(a)

Système chauffant

(b)

Mode statique

Mode dynamique

**FIGURE 1**

Couche de
Nanotubes de
carbone

Dopage

Couche de graphène

**FIGURE 2**

**FIGURE 3**

Masque

Défilement

Système chauffant

Zone avec un dopage plus faible

Zone dopée

Zone non dopée

Vue de dessus

**FIGURE 4**

Europäisches Patentamt

European Patent Office

Office européen des brevets

## RAPPORT DE RECHERCHE EUROPEENNE

Numéro de la demande

EP 18 19 9969

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WOOSEOK SONG ET AL: "Anchoring Au and Pt Nanoparticles on Multiwalled Carbon Nanotubes via Electron Beam Induced Amorphous Carbon Encapsulation", JAPANESE JOURNAL OF APPLIED PHYSICS, JAPAN SOCIETY OF APPLIED PHYSICS, JP, vol. 50, no. 4 - PT1, 1 avril 2011 (2011-04-01), pages 45102-1-45102-4, XP001564334, ISSN: 0021-4922, DOI: 10.1143/JJAP.50.045102 [extrait le 2011-04-20] | 1-5,7-9, 14-16 | INV. C01B32/168 C23C16/26 H01B1/04 H01B5/14 H01L29/12 H01M4/62 H01L51/00 |
| Y | * pages 45102-1 - pages 45102-3 * * figures 4,5 * ----- | 6,10-13 | |
| X | PINITHCHAISAKULA A ET AL: "Efficiency of bimetallic PtPd on polydopamine modified on various carbon supports for alcohol oxidations", CHEMICAL PHYSICS, NORTH-HOLLAND, NL, vol. 483, 17 novembre 2016 (2016-11-17), pages 56-67, XP029918532, ISSN: 0301-0104, DOI: 10.1016/J.CHEMPHYS.2016.11.010 | 1-5,7,8, 14-16 | DOMAINES TECHNIQUES RECHERCHES (IPC) C01B C23C H01B H01L H01M |
| Y | * pages 56-66 * * figures 1-6 * * tableaux 1-3 * ----- | 6,10-13 | |
| X | US 2013/260550 A1 (VEERASAMY VIJAYEN S [US]) 3 octobre 2013 (2013-10-03) | 14-16 | |
| Y | * figures 1-14 * * alinéas [0001], [0006] - [0108] * ----- | 10,13 | |
| X | US 2013/236753 A1 (YUE SEONG-HOON [KR] ET AL) 12 septembre 2013 (2013-09-12) * alinéas [0001], [0064] - [0066] * ----- | 14-16 | |

-/--

Le présent rapport a été établi pour toutes les revendications

| Lieu de la recherche | Date d'achèvement de la recherche | Examinateur |
|---|---|---|
| La Haye | 14 janvier 2019 | Marino, Emanuela |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 2

Europäisches Patentamt

European Patent Office

Office européen des brevets

# RAPPORT DE RECHERCHE EUROPEENNE

Numéro de la demande

EP 18 19 9969

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | YONG SEOB PARK ET AL: "The effects of annealing temperature on the characteristics of carbon counter electrodes for dye-sensitized solar cells", CURRENT APPLIED PHYSICS, NORTH-HOLLAND, AMSTERDAM, NL, vol. 11, no. 4, 11 janvier 2011 (2011-01-11), pages 989-994, XP028217889, ISSN: 1567-1739, DOI: 10.1016/J.CAP.2011.01.004 [extrait le 2011-01-21] * alinéa [introduction] *<br>----- | 6 | |
| A | US 2017/002212 A1 (HEINTZ AMY M [US] ET AL) 5 janvier 2017 (2017-01-05) * alinéas [0009] - [0049] *<br>----- | 1-16 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 14 janvier 2019 | Marino, Emanuela |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 2 de 2

**ANNEXE AU RAPPORT DE RECHERCHE EUROPEENNE
RELATIF A LA DEMANDE DE BREVET EUROPEEN NO.**

EP 18 19 9969

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-01-2019

| Document brevet cité au rapport de recherche | Date de publication | Membre(s) de la famille de brevet(s) | Date de publication |
|---|---|---|---|
| US 2013260550 A1 | 03-10-2013 | BR 112012022115 A2 | 25-10-2016 |
| | | CN 102782054 A | 14-11-2012 |
| | | EP 2542627 A1 | 09-01-2013 |
| | | JP 5690852 B2 | 25-03-2015 |
| | | JP 2013527790 A | 04-07-2013 |
| | | KR 20130058662 A | 04-06-2013 |
| | | RU 2012142176 A | 10-04-2014 |
| | | TW 201134896 A | 16-10-2011 |
| | | US 2011217455 A1 | 08-09-2011 |
| | | US 2013260550 A1 | 03-10-2013 |
| | | WO 2011109121 A1 | 09-09-2011 |
| US 2013236753 A1 | 12-09-2013 | CN 103210539 A | 17-07-2013 |
| | | DE 112011103795 T5 | 12-09-2013 |
| | | KR 20120053476 A | 25-05-2012 |
| | | US 2013236753 A1 | 12-09-2013 |
| | | US 2016190660 A1 | 30-06-2016 |
| | | WO 2012067432 A2 | 24-05-2012 |
| US 2017002212 A1 | 05-01-2017 | EP 1996512 A2 | 03-12-2008 |
| | | EP 2374754 A1 | 12-10-2011 |
| | | JP 2009536911 A | 22-10-2009 |
| | | KR 20080098664 A | 11-11-2008 |
| | | US 2009142581 A1 | 04-06-2009 |
| | | US 2016268014 A1 | 15-09-2016 |
| | | US 2017002212 A1 | 05-01-2017 |
| | | WO 2008054473 A2 | 08-05-2008 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A.G. NASIBULIN et al.** *Chemical Physics Letters,* 2007, vol. 446, 109-114
- **RALF GRAUPNER.** *Phys. Chem. Chem. Phys.,* 2003, vol. 5, 5472-5476
- **KIM et al.** *acsnano,* 2011, vol. 5 (2), 1236-1242
- **KIM et al.** *acsnano,* 2009, vol. 3 (9), 2818-2826
- *Nanotechnology,* 2008, vol. 19, 205703
- *Science and Technology of Advanced Materials,* 2016, vol. 17 (1), 493-516
- *Adv. Funct. Mater.,* 2010, vol. 20, 885-891
- **A. KASKELA et al.** *Carbon,* 2016, vol. 103, 228-234
- *ACS Nano,* 2008, vol. 2 (9), 1871-1878
- **Y. HAYAMIZU.** *nature nano,* 2008, vol. 3, 289
- *carbon,* 2013, vol. 60, 139-145